Europäisches Patentamt

European Patent Office

Office européen des brevets

(19)

(11) Publication number: **0 021 018**
**B1**

(12) **EUROPEAN PATENT SPECIFICATION**

(45) Date of publication of patent specification: **08.08.84**

(51) Int. Cl.³: **H 03 H 17/02**

(21) Application number: **80102726.9**

(22) Date of filing: **16.05.80**

(54) **Digital filters.**

(30) Priority: **16.05.79 JP 59895/79**

(43) Date of publication of application:
**07.01.81 Bulletin 81/1**

(45) Publication of the grant of the patent:
**08.08.84 Bulletin 84/32**

(84) Designated Contracting States:
**DE FR GB NL**

(56) References cited:
**FR - A - 2 425 773**
**GB - A - 2 003 690**
**US - A - 3 777 130**

**IEEE TRANSACTIONS ON COMPUTERS, vol. 25,
nr. 10, October 1976 NEW YORK (US) SHALHAV
ZOHAR: "A realization of the RAM digital filter",
pages 1048-1052**

(73) Proprietor: **NEC CORPORATION**
**33-1, Shiba 5-chome, Minato-ku**
**Tokyo 108 (JP)**

(72) Inventor: **Nakayama, Kenji**
**c/o Nippon Electric Co., Ltd. 33-1, Shiba Gochome**
**Minato-ku, Tokyo (JP)**

(74) Representative: **Kehl, Günther, Dipl.-Ing. et al,**
**Patentanwälte GEYER, HAGEMANN & KEHL**
**Ismaninger Strasse 108 Postfach 86 03 29**
**D-8000 München 86 (DE)**

The file contains technical information
submitted after the application was filed and not
included in this specification

Courier Press, Leamington Spa, England.

# Description

Background of the invention

This invention generally relates to a digital filter, and more particularly to a digital filter which sequentially delays a binary coded input for producing an output accruing from weighting and adding of the input delayed.

In a digital filter, an output at a given time is determined according to a past output and a weighted sum of the past and present inputs. In principle, such a digital filter comprises a plurality of multipliers for applying a plurality of weights to the input signal, a delay circuit for delaying the outputs of respective multipliers, and an adder which adds together the output of a multiplier of a succeeding stage and the output of a multiplier of a preceding stage. However, in a digital filter of high order, it is necessary to provide a multiplier, a delay circuit and an adder for each weighting stage, thus requiring a large number of such circuit elements. Especially, provision of a plurality of stages of such complicated circuits as the multipliers increases the number of the arithmetic operations, thus increasing the size of the filter.

An approach to this problem is disclosed in U.S. Patent No. 3,777,130 to Croisier et al entitled "Digital Filter for PCM Encoded Signals". The filter disclosed in U.S. Patent No. 3,777,130 comprises an accumulator for multiplying and summing a weighted hybrid value obtained from a memory medium addressed by a selected one of W bits of each of n digitally encoded signal samples. By addressing the memory with the binary value of like bit positions of the signal samples, then a hybrid value may be stored, which hybrid value need only be multiplied and combined by the accumulator. This permits the use of a substantially smaller memory than that required if the digits of the signals looked up by completed weighted function.

Summary of the invention

The present invention also contemplates an approach to a similar problem and starts from a digital filter of the type already known from U.S. Patent No. 3,777,130, i.e. the present invention starts from a digital filter including means for weighting binary coded input data X(n) by binary coded weight data $a_l$, said means including: a read/write memory device; means for accessing said read/write memory device; and means for shifting the data to be filtered and accumulating the obtained results to produce a weighted input data X(n).

The problem underlying the present invention is to improve a digital filter of the above mentioned known type such that the memory capacity is reduced.

This problem is solved by further developing the above mentioned digital filter of said known type such that said weighting means are ranged and designed for applying a plurality of said coded weight data $a_l$ to each of said binary coded input data X(n); said weighting means further including means for multiplying anyone integer from 0 to $2^M-1$, —where M is the number of bits of said weight data $a_l$ or is the number of bits of partial weight data $a_{ij}$, j=1, ..., K obtained by a division of said weight data $a_l$ into K partial data each of M bits—, by said input data X(n) and means for storing a result of said multiplication operation in an address l, corresponding to said integer, of said read/write memory device; said memory accessing means are ranged and designed for accessing said read/write memory device by address signals obtained from said weight data $a_l$ or said partial weight data $a_{ij}$; and said data shifting and accumulating means are ranged and designed for accumulating results corresponding to K partial weight data $a_{ij}$ to produce a product $Y_l(n)$ of said input data X(n) and said weight data $a_l$; and further means connected to the output of said weight applying means are provided for adding together a product regarding a preceding input data X(n−1) and product regarding a succeeding input data X(n) to produce a filter output Y(n).

The digital filter according to the present invention has—besides the improvement of the digital filter known from U.S. Patent No. 3,777,130 in the memory capacity reduction—the advantage that it is suitable for multiplying the input data by a plurality of weight data through a small number of arithmetic operations and hence being small in size. Moreover the filter of the present invention is capable of readily changing the input data and the application to adaptive filters is facilitated.

According to a preferred embodiment of this invention the shifting and accumulating means are ranged and designed for shifting the data read out of said read/write memory device by $M_o-jM$ bits, where $M_o$ is the most significant bit of said weight data $a_l$.

Preferably this shifting is accomplished by means for shifting the input data X(n) by $M_o-M$ bits prior to its entry into said multiplying means and means for shifting the data read out of said read/write memory device by $-jM$ bits.

The multiplication of said input data X(n) by said integer is perferably effected according to the following equation,

$$XI=X(I-1)+X$$

where X represents an input data and I an address number being not less than 1.

Brief description of the drawings

In the accompanying drawings:

Fig. 1 is a diagrammatic representation of a circuit construction showing the principle of a known digital filter;

Fig. 2 is similar diagrammatic representation showing another known basic construction;

Fig. 3 is a connection diagram showing one example of a weighting circuit utilized in a digital filter embodying the invention;

Fig. 4 is a diagrammatic connection diagram showing input and output signals, a weighting signal and a delayed output of a weighting circuit;

Fig. 5 is a connection diagram showing a circuit construction in which the filter shown in Fig. 4 is constructed by utilizing the weighting circuit shown in Fig. 3; and

Fig. 6 is a time chart useful to explain the operations of the circuits shown in Figs. 3 and 5.

Description of the preferred embodiments

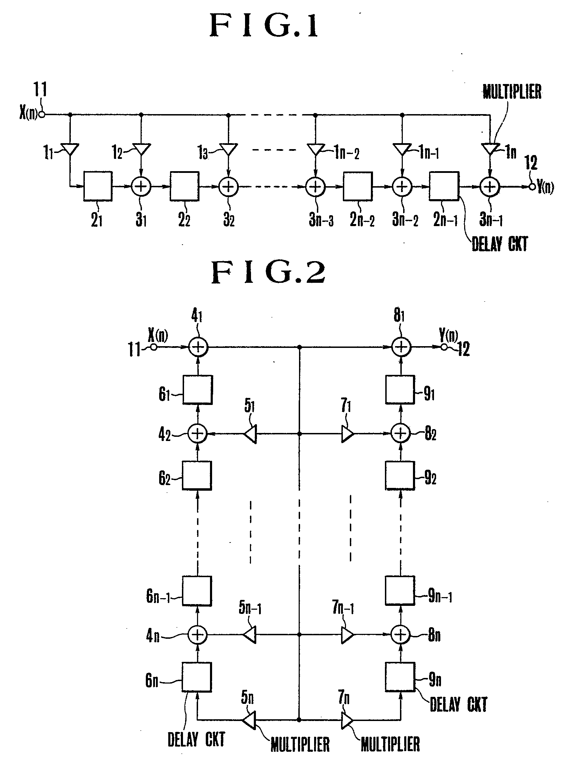

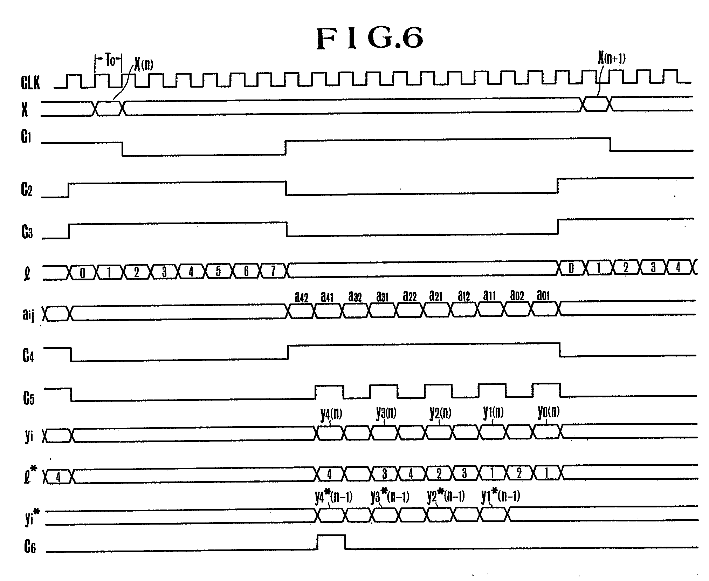

Referring now to Fig. 1, in a digital filter diagrammatically illustrated in Fig. 1, an input signal $X(n)$ supplied to an input terminal 11 is sequentially multiplied by a plurality of weight data $a_1$ to $a_n$ at n (an integer) multipliers $1_1$ to $1_n$ and the output of a multiplier $1_1$ is delayed by a sampling period T (equal to a time interval between $X(n)$ and $X(n+1)$ shown in Fig. 6) of the input signal $X(n)$ by a delay circuit $2_1$ and then added together with the output of the multiplier $1_2$ by an adder $3_1$. The output of the adder $3_1$ is delayed by the interval T by a delay circuit $2_2$ and then added to the output of a multiplier $1_3$ by an adder $3_2$. In the same manner, the outputs of the adders are sequentially delayed by the sampling period T and added together with the outputs of the multipliers succeeding the respective delay circuits and the output of the adder $3_{n-1}$ of the last stage is applied to an output terminal 12 as a filtered output $Y(n)$.

Fig. 2 is a diagrammatical representation of a so-called recursive type digital filter, in which an input signal $X(n)$ applied to the input terminal 11 is added together with the output of a delay circuit $6_1$ by an adder $4_1$, and the output of the adder $4_1$ is multiplied by weight data $b_1$ to $b_n$ respectively by n multipliers $5_1$ to $5_n$, and also multiplied with respective constants $C_1$ to $C_n$ by multipliers $7_1$ to $7_n$. The output of the adder $4_1$ is also added to an adder $8_1$. The outputs of respective multipliers $5_1$ to $5_{n-1}$ are applied to respective adders $4_2$ to $4_n$ and the outputs thereof are applied to adders $4_1$ to $4_{n-1}$ respectively through the delay circuits $6_1$ to $6_{n-1}$ each having a delay time corresponding to the sampling period T. The output of an multiplier $5_n$ is supplied to the adder $4_n$ via delay circuit $6_n$. The outputs of multipliers $7_1$ to $7_{n-1}$ are supplied to adders $8_2$ to $8_n$ respectively and the outputs thereof are supplied to adders $8_1$ to $8_{n-1}$ respectively through delay circuits $9_1$ to $9_{n-1}$. The output of the multiplier $7_n$ is applied to the adder $8_n$ via a delay circuit $9_n$ and the output of the adder $8_1$ is applied to an output terminal 12 as a filtered output $Y(n)$.

With a digital filter as shown in Fig. 1 the same input $X(n)$ is multiplied by n times by the multipliers $1_1$ to $1_n$, whereas with the digital filter as shown in Fig. 2, the same output of the adder $4_1$ is multiplied by 2n times by the multipliers $5_1$ to $5_n$ and $7_1$ to $7_n$. Assuming that the number of bits of each weight data $a_i$ is equal to p, for example, during the multiplying operations, an addition operation of a multiplier is executed $(p-1)$ times so that with n multipliers, addition operations are performed $n(p-1)$ times, thus greatly increasing the total number of the addition operations. Furthermore the digital filter shown in Fig. 1 requires n multipliers, whereas the digital filter shown in Fig. 2 requires 2n multipliers, so that the circuit construction of the multipliers becomes complicated. In this manner, increase in the number of the multipliers increases the size of the filter circuit.

The invention contemplates decrease in the number of the multipliers necessary to execute multiplying operations in which the same input X is multiplied by respective weight data $a_i$ in order to obtain the outputs of the digital filter of the type described above, and the present invention is based on the following principle.

For example, consider multiplication of the same data X by a weight data $a_i$ ($i=0, 1, 2 \ldots n-1$), that is, computation of the following equation (1)

$$y_i = a_i X \qquad (1)$$

When it is assumed that $a_i$ consists of $K \times M$ bits except for the sign bit, that its most significant bit is Mo, and that the sign bit is $a_{is}$, by dividing the weight data $a_i$ into K partial weight data $a_{ij}$; $j=1, \ldots, K$ of M bits as shown by the following equation

$$a_i = 2^{Mo} \sum_{j=1}^{K} a_{is} \, a_{ij} \, 2^{-jM} \qquad (2),$$

the data X is multiplied by the partial weight data according to the following equation

$$y_i = a_{is} \sum_{j=1}^{K} (a_{ij} X) \, 2^{Mo-jM} \qquad (3)$$

Since in equation (3) the number which the partial weight data $a_{ij}$ can take is only $2^M$ (that is 0, 1 $\ldots 2^M-1$), $a_{ij}X$ can be obtained by previously calculating $Xl(l=0, 1 \ldots 2^M-1)$ for the input X, then storing the calculated Xl in an address l of a memory device, and by accessing independently the stored Xl by an address of $a_{ij}$.

This Xl can be used in common for all $a_{ij}$ (where $i=0, 1 \ldots n-1$, and $J=1, 2 \ldots K$) and the Xl can be obtained by repeatedly calculating an equation

$$Xl = X(l-1) + X \qquad (4)$$

for $l=1, 2 \ldots 2^M-1$ without performing a multiplying operation. Thus, the operation for obtaining $y_i$ involves reading out of $a_{ij}X$, shifting read out data bit by $Mo-jM$ and multiplying with $a_{is}$.

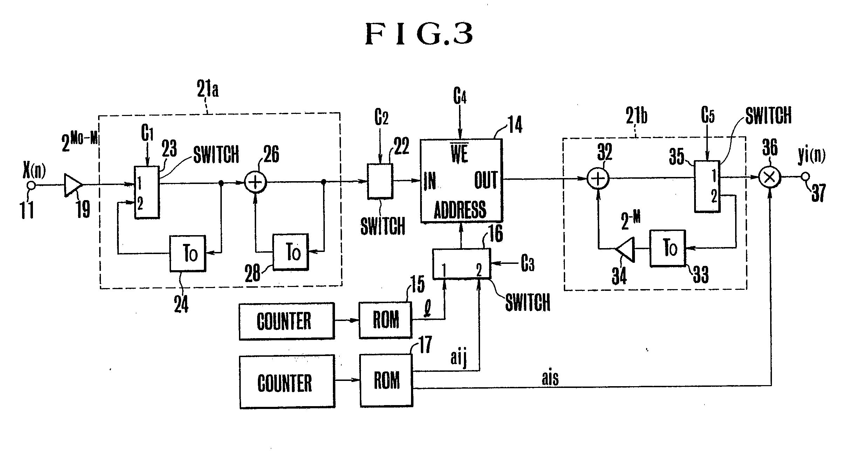

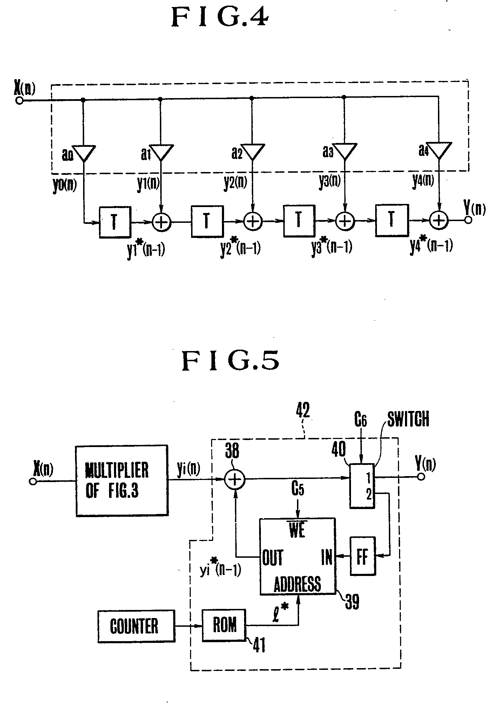

One example of the construction of a multiplier (wherein $N-1=4$) utilizing such an algorithm will now be described with reference to Fig. 3. As shown, a read/write memory device, i.e., a RAM 14 is provided which can be accessed by an address signal $l(l=0, 1, \ldots 2^M-1)$ generated by an address generator 15 comprising a ROM supplied through a contact 1 of a switch 16. The memory device 14 can also be accessed by a partial data $a_{ij}$ generated by a data generator 17 comprising a ROM through contact 2 of the switch 16. An input data $X(n)$ supplied to an input terminal 11 is multiplied by a multiplier 19 by $2^{Mo-M}$ so that the digit of the input data is shifted by $Mo-M$, and supplied via a contact 1 of a switch 23 to a multiplier section 21a, the output thereof being applied to the memory device 14 as a write data via a switch 22. The multiplier section 21a multiplies the input data $X(n)$ by any integer from 0 to $2^{M-1}$, i.e an integer that can be expressed by M bits according to equation (4), in this example. The switch 23 is thrown between contact 1 on the side of the multiplier 19 and a contact 2 on the output side of a delay circuit 24 having a delay time to $T_0$ (equal to a clock period as shown in Fig. 6). One input of an adder 26 is connected to the contact 2 of the switch 23 and the input of the delay circuit 24, while the output of the adder 26 is connected to the other input thereof through a delay circuit 28 having a delay time of $T_0$.

When the contact 1 of the switch 16 and the switch 22 are both closed and when the address generator 15 produces an address signal $l="1"$, the input data $X(n)$ is multiplied by $2^{Mo-M}$ at the multiplier 19 and this product $X'(n)=X(n)2^{Mo-M}$ or $X'=X 2^{Mo-M}$ is applied to the adder 26 via contact 1 of switch 23 to be stored in the address $l="1"$ of the memory device 14 via switch 22.

At the next step, the switch 23 is thrown to the contact 2 connected to the delay circuit 24 whereby the outputs of both delay circuits 24 and 28 are added together with the result that the sum $2X'(n)$ is stored in the address "2" of the memory device 14. The operation described above is repeated until an address $l=2^M-1$ is reached.

When the writing into the memory device 14 is completed in this manner, partial weight data pattern $a_{ij}$ of the data $a_i$ to be multiplied is generated by the data generator 17 in the order of $j=K, K-1, K-2 \ldots 1$, that is, from the least significant bit. Such partial weight data are used as addresses to access the memory device 14. At this time, the contact 1 of switch 16 and the switch 22 are opened and the contact 2 of switch 16 is closed. The read out partial product data, i.e. the product of $X(n)$, $2^{Mo-M}$ and the partial weight data $a_{ij}$, is applied to an adder 32 of a multiplier section 21b. The digit of the output of the adder 32 is shifted by the number of bits of the partial weight data and then accumulated or added with a partial product read out next time. In other words, the output of the adder 32 is applied to a delay circuit 33 having a delay time of $T_0$ via the contact 2 of a switch 35 and the output of the delay circuit 33 is multiplied by $2^{-M}$ at a multiplier 34 to shift by $-M$ digits and then supplied to the adder 32. Thus, the multiplier 34 is required to shift only by M digits the output of the delay circuit 33.

A partial weight data pattern $a_{ij}$ is sequentially generated starting from its least significant bit for reading out a corresponding partial product which is shifted to a lower digit by a number of bits of the partial weight data and added to a partial product read out next time. This operation is repeated. A $j=1$ of the partial weight data $a_{ij}$ is applied to the memory device 14 to read out a corresponding partial product which is accumulated by the adder 32 so that it produces an output $|a_i|X(n)$. Concurrently therewith switch 35 is thrown to contact 1 and its output is multiplied by the sign bit $a_{is}$ of $a_i$ at a multiplier 36 which gives its output $y_i(n)$ to an output terminal 37.

By repeatedly reading out the memory device 14 with respect to respective data $_i$ ($i=0$ to 4), an output $y_i(n)$ ($i=0$ to 4) can be obtained.

The timings of respective signals are shown in a timing chart shown in Fig. 6. Where the control signals applied to switches 16, 22 and 35 are 2 inputs-one output and one input-2 outputs, these switches are thrown to their contacts 1 when $Ci="1"$ ($i=1$ to 5) whereas to their contacts 2 when $Ci="0"$, but in the case of one input-one output these switches are closed when $Ci="1"$ and opened when $Ci="0"$.

The terminal $\overline{WE}$ of RAM 14 becomes a read out mode when $Ci="1"$ so that the contents can be read out when an address signal is inputted, whereas when $Ci$ is "0" the terminal $\overline{WE}$ becomes a write mode so that upon application of an address signal and data, the data can be written in.

Where the number of the weight data $a_i$ is 100, the word length of the weight data $a_i$ is 13 bits (including a sign) and the bit number M of the partial weight data $a_{ij}$ is equal to 4 bits, the number of the addition operations at the multiplier section 21a for writing into the memory 14 becomes $2^M=2^4=16$. The number of the addition operations of the adder 32 at the time of reading out the memory device 14 becomes a product $3 \times 100=300$ of the number 3 of the divided partial weight data $a_{ij}$ and the number n of the coefficients $a_i$. Accordingly, it is necessary to perform a total of $16+300=316$ addition operations.

On the other hand, with the construction shown in Fig. 1, one multiplying operation of X and the weight data $a_i$ of 13 bits is performed by 12 addition operations, and since $a_i$ is 100, the total number of the addition operations is

$12 \times 100 = 1200$. Comparison of this value with 316 of this invention shows that the scale of the arithmetic operation of this invention is reduced by about 1/4.

Especially, where the value n of the weight data $a_i$ is large and when it is divided into partial weight data $a_{ij}$ there are a plurality of sets having the same value among the entire partial weight data pattern. In this case, the scale of the aritmetic operation can be reduced greatly in accordance with the invention. After writing and reading into and out of the memory device 14 one sample input data $X(n)$, a similar operation is repeated for the next input data $X(n+1)$. If possible, the address generator 15 and the coefficient generator 17 may be combined into one unit. Operations described above can be performed by executing a program with a microcomputer, in which case a portion of a random access memory may be used as delay circuits 24, 28 and 33.

The digital filter shown in Fig. 1 and having the number of order of 4 is shown in Fig. 4 in which $a_i$ ($i=0$ to $4$) represents a multiplier for respective multipliers, $Y_i(n)$ represents the output of each multiplier at a time n, $X(n)$ an input signal at the time n, $Y_i^*(n-1)$ the output of each delay circuit at the time n, $Y(n)$ the output signal at the time n.

A digital filter arrangement equivalent to that shown in Fig. 4 and having a time division multiplexed construction is formed as shown in Fig. 5 by using the circuit shown in Fig. 3. As has been described hereinabove, it is possible to obtain an output $Yi(n)$ for an input $X(n)$ with the multiplier shown in Fig. 3. In the digital filter shown in Fig. 5, this output is sequentially added to the output $Y_i^*(n-1)$ from a memory device 39 (RAM) by an adder 38 in an addition unit 42. This operation is performed according to the order of $i=4, 3, 2, 1, 0$ and a data $Y_4(n)+Y_4^*(n-1)$ is outputted through a switch 40 as the output $Y(n)$ of the filter. The switch 40 is thrown to contact 1 when $C6="1"$ but to contact 2 when $C6="0"$. The next output $Y_3(n)+Y_3^*(n-1)$ is stored in an address $I^*=4$ of the memory device 39 as data $Y_4^*(n)$ by being addressed by an address $I^*$ from a memory device (ROM) 41'. Under these conditions, the switch 40 is thrown to contact 2. This operation is performed for $i=3$ to $0$, provided that $Y_0^*(n-1)="0"$. The above described operation corresponds to the operation over one cycle between inputting of $X(n)$ and outputting of $Y(n)$ with the circuit shown in Fig. 4.

Counters connected to the memories 15, 17 and 41 serve to apply an address signal to these memories. A flip-flop circuit FF in Fig. 5 is adapted to delay the operation of the memory 39 between reading of the present data and writing of the preceding data. Also, it will be appreciated that in Fig. 6 the time chart is illustrated for the case wherein the partial weight data $a_{ij}$ is divided into two partial data each having 3 bits. Accordingly, I is shown for $M=3$

and $a_{ij}$ is shown for $K=2$. Further, it will be seen from Fig. 6 that $Y_4(n)$ is derived from $a_{42}$ and $a_{41}$ and $Y_3(n)$ from $a_{32}$ and $a_{31}$, and that $Y_3(n)+Y_3^*(n-1)$ is read at $I^*=3$ and input into the memory 39 at $I^*=4$. This delay is produced by the flip-flop circuit FF. Furthermore, the overall sequence is timed with clock CLK in Fig. 6 and the delay time $T_0$ corresponds to the period of the clock.

## Claims

1. A digital filter including

a) means (14, 15, 17, 19, 21a, 21b, 36) for weighting binary coded input data ($X(n)$) by binary coded weight data ($a_i$) said means including:

a.1) a read/write memory device (14);

a.2) means (17) for accessing said read/write memory device (14); and

a.3) means (19; 21b) for shifting the data to be filtered and accumulating the obtained results to produce a weighed input data ($X(n)$) characterized in that

b) said weighting means (14, 15, 17, 19, 21a, 21b, 36) are ranged and designed for applying a plurality of said weight data ($a_i$) to each of said input data ($X(n)$);

b.1) said weighting means further including means (21a) for multiplying anyone integer from 0 to $2^M-1$, —where M is the number of bits of said weight data ($a_i$) or is the number of bits of partial weight data ($a_{ij}$, $j=1, ..., K$) obtained by a division of said weight data ($a_i$) into K partial data each of M bits —, by said input data ($X(n)$) and means (15) for storing a result of said multiplication operation in an address (I), corresponding to said integer, of said read/write memory device (14);

b.2) said memory accessing means (17) are ranged and designed for accessing said read/write memory device (14) by addresss signals obtained from said weight data ($a_i$) or said partial weight data ($a_{ij}$); and

b.3) said data shifting and accumulating means (19; 21b) are ranged and designed for accumulating results corresponding to said K partial weight data ($a_{ij}$) to produce a product ($Y_i(n)$) of said input data ($X(n)$) and said weight data ($a_i$); and

c) means (42) connected to the output of said weight applying means (14, 15, 17, 19, 21a, 21b, 36) are provided for adding together a product regarding a preceding input data ($X(n-1)$) and a product regarding a succeeding input data ($X(n)$) to produce a filter output ($Y(n)$).

2. The digital filter according to claim 1, wherein said shifting and accumulating means (19; 21b) are ranged and designed for shifting the data read out of said read/-write memory device (14) by $M_o-jM$ bits, where $M_o$ is the most significant bit of said weight data $a_i$.

3. The digital filter according to claim 2, wherein said shifting and accumulating means (19; 21b) includes means for shifting the input data (X(n)) by $M_o-M$ bits prior to its entry into said multiplying means (21a) and means (21b) for shifting the data read out of said read/write memory device (14) by $-jM$ bits.

4. The digital filter according to anyone of the claims 1 to 3, wherein the multiplication of said input data (X(n)) by said integer is effected according to the following equation,

$$XI=X(I-1)+X$$

where X represents an input data and I an address number being not less than 1.

**Patentansprüche**

1. Digitales Filter mit

a) Mitteln (14, 15, 17, 19, 21a, 21b, 36) zur Gewichtung von binär kodierten Eingangsdaten (X(n)) durch binär kodierte Gewichtungsdaten (a$_l$), welche Mittel folgendes enthalten:
a.1) eine Lese/Schreib-Speicheranordnung (14);
a.2) Mittel (17) zum Zugreifen zu der Lese-/Schreib-Speicheranordnung (14); und
a.3) Mittel 19; 21b) zum Verschieben der zu filternden Daten und zum Akkumulieren der erhaltenen Ergebnisse zur Erzeugung eines gewichteten Datenwertes (X(n)), dadurch gekennzeichnet, daß
b) die Mittel zur Gewichtung (14, 15, 17, 19, 21a, 21b, 36) so dimensioniert und ausgelegt sind, daß eine Vielzahl der Gewichtungsdaten (a$_l$) auf jedes der Eingangsdaten (X(n)) angewandt wird;
b.1) die Mittel zur Gewichtung des weiteren Mittel (21a) enthalten zum Multiplizieren einer beliebigen ganzen Zahl von 0 bis $2^M-1$, —wobei M die Anzahl der Bits des Gewichtungsdatenwertes (a$_l$) oder die Anzahl der Bits von partiellen Gewichtungsdaten (a$_{ij}$, j=1, ..., K) ist, die aus einer Teilung der Gewichtungsdaten (a$_l$) in K partialdaten von jeweils M bits erhalten werden—, mit den Eingangsdaten (X(n)) sowie Mittel (15) zum Speichern eines Ergebnisses des Multiplikationsvorganges in einer der genannten ganzen Zahl entsprechenden Adresse (1) der Lese/Schreib-Speicheranordnung (14);
b.2) daß die Speicherzugriffsmittel (17) so dimensioniert und ausgelegt sind, daß der Zugriff zu der Lese/Schreib-Speicheranordnung (14) durch Adressensignale erfolgt, dia aus den Gewichtungsdaten (a$_l$) oder den Partialgewichtungsdaten (a$_{ij}$) erhalten werden; und
b.3) daß die Datenverschiebe- und Gewichtungsmittel (19; 21b) so dimensioniert und ausgelegt sind, um die den K partialgewichtungsdaten (a$_{ij}$) entsprechenden Ergebnisse zu akkumulieren, um ein Produkt ($Y_i$(n)) aus den Eingangsdaten (X(n)) und den Gewichtungsdaten (a$_l$) zu bilden; und

c) daß Mittel (42) vorgesehen sind, die an die Ausgänge der Gewichtungsmittel (14, 15, 17, 19, 21a, 21b, 36) angeschlossen sind, um ein Produkt betreffend einen vorausgegangenen Eingangsdatenwert (X(n—1)) und ein Produkt betreffend einen nachfolgenden Eingangsdatenwert (X(n)) zu addieren, um ein Filterausgangssignal (Y(n)) zu erhalten.

2. Digitales Filter nach Anspruch 1, bei dem die Verschiebe- und Akkumuliermittel (19; 21b) so dimensioniert und ausgelegt sind, um die aus der Lese/Schreibspeicheranordnung (14) ausgelesenen Daten um $M_o-jM$ Bits zu verschieben, wobei $M_o$ das Bit mit der höchsten Wertigkeit des Gewichtungsdatenwertes a$_l$ ist.

3. Digitales Filter nach Anspruch 2, bei dem die Verschiebe- und Akkumuliermittel (1; 21b) Mittel zum Verschieben der Eingangsdaten (X(n)) um $M_o-M$ Bits vor ihrer Eingabe in die Multiplikationsmittel (21a) und Mittel (21b) zum Verschieben um $-jM$ Bits der aus der Lese/Schreib-Speicheranordnung (14) ausgelesenen Daten aufweisen.

4. Digitales Filter nach einem der Ansprüche 1 bis 3, bei dem die Multiplikation der Eingangsdaten (X(n)) mit der genannten ganzen Zahl nach folgender Gleichung erfolgt

$$XI=X(I-1)+X,$$

wobei X einen Eingangsdatenwert und I eine Adressenzahl, die nicht kleiner als 1 ist repräsentieren.

**Revendications**

1. Filtre numérique comprenant:

a) des moyens (14, 15, 17, 19, 21a, 21b, 36) pour pondérer des données d'entrée codées en binaire (X(n)) par des données de poids codées en binaire (a$_l$), ces moyens comprenant:
a.1) un dispositif à mémoire d'écriture:lecture (14);
a.2) des moyens (17) pour accéder au dispositif à mémoire de lecture/écriture (14); et
a.3) des moyens 19; 21b) pour décaler les données à filtrer et accumuler les résultats obtenus afin de produire une donnée d'entrée pondérée (X(n)), caractérisé en ce que:
b) les moyens de pondération (14, 15, 17, 19, 21a, 21b, 36) ont une capacité et sont conçus pour appliquer une pluralité des données de poids (a$_l$) à chacune des données d'entrée (X(n));
b.1) les moyens de pondération comprenant d'autre part un moyen (21a) pour multiplier un nombre entier quelconque compris entre 0 et $2^M-1$, —où M est le nombre de bits des

données de poids (a$_i$) ou le nombre de bits de données partielles de poids (a$_{ij}$, j=1 ...K) obtenues par une division des données de poids (a$_i$) en K données partielles de M bits chacune—, par la donnée d'entrée (X(n)) et un moyen (15) pour stocker un résultat de l'opération de multiplication dans une adresse (I), correspondant au nombre entier, du dispositif à mémoire de lecture/écriture (14);

b.2) les moyens (17) d'accès à la mémoire ont une capacité et sont conçus pour accéder au dispositif à mémoire de lecture/écriture (14) par des signaux d'adresse provenant des données de poids (a$_i$) ou de données partielles de poids (a$_{ij}$); et

b.3) les moyens de décalage et d'accumulation de données (19; 21b) ont une capacité et sont conçus pour accumuler des résultats correspondant aux K données partielles de poids (a$_{ij}$) afin de former un produit (Y$_i$(n)) des données d'entrée (X(n)) et des données de poids (a$_i$); et

c) des moyens (42) connectés à la sortie des moyens d'application de poids (14, 15, 17, 19, 21a, 21b, 36) sont prévus pour ajouter ensemble un produit concernant une donnée d'entrée précédente (X(n—1)) et un produit concernant une donnée d'entrée suivante (X(n)) afin de donner une sortie de filtre (Y(n)).

2. Filtre numérique selon la revendication 1, où les moyens de décalage et d'accumulation (19; 21b) ont une capacité et sont conçus pour décaler la donnée lue dans le dispositif à mémoire de lecture/écriture (14) de M$_o$—jM bits, où M$_o$ est le bit de poids fort des données de poids a$_i$.

3. Filtre numérique selon la revendication 2, où les moyens de décalage et d'accumulation (19; 21b) comprennent un moyen pour décaler la donnée d'entrée (X(n)) de M$_o$—M bits avant son entrée dans le moyen de multiplication (21a) et un moyen (21b) pour décaler la donnée lue dans le dispositif à mémoire de lecture/écriture (14) de —jM bits.

4. Filtre numérique selon l'une quelconque des revendications 1 à 3, où la multiplication de la donnée d'entrée (X(n)) par le nombre entier est effectuée conformément à l'équation suivante:

$$XI = X(I-1) + X$$

où X représente une donnée d'entrée et I un nombre d'adresses qui n'est pas inférieur à 1.

# FIG.1

# FIG.2

# F I G.3

# F I G.4

# F I G.5

# FIG.6

0 021 018

CLK

$T_0$  $X(n)$  $X(n+1)$

X

$C_1$

$C_2$

$C_3$

$\ell$  0 1 2 3 4 5 6 7  0 1 2 3 4

$a_{ij}$  $a_{42}$ $a_{41}$ $a_{32}$ $a_{31}$ $a_{22}$ $a_{21}$ $a_{12}$ $a_{11}$ $a_{02}$ $a_{01}$

$C_4$

$C_5$

$y_i$  $y_4(n)$ $y_3(n)$ $y_2(n)$ $y_1(n)$ $y_0(n)$

$\ell^*$  4  4 3 4 2 3 1 2 1

$y_i^*$  $y_4^*(n-1)$ $y_3^*(n-1)$ $y_2^*(n-1)$ $y_1^*(n-1)$

$C_6$